# DEMANDE DE BREVET EUROPEEN

(11) **EP 1 304 734 A2**
(43) Date de publication de la demande: **23.04.2003**
(21) Numéro de dépôt: 02292537.4
(22) Date de dépôt: 15.10.2002
(51) Int. Cl.: H01L 21/764, H01L 21/762

(54) **Tranchée d'isolation et procédé de réalisation**

(30) Priorité: 17.10.2001 FR 0113375
(71) Demandeur: STMicroelectronics S.A., 92120 Montrouge (FR)
(72) Inventeur: Marty, Michel, 38760 Varces (FR); Leverd, François, 38330 Saint Ismier (FR); Coronel, Philippe, 38530 Barraux (FR); Torres, Joaquin, 38950 Saint Martin le Vinoux (FR)
(74) Mandataire: Simonnet, Christine

(57) **Abrégé**

Il s'agit d'une tranchée d'isolement creusée dans un substrat semi-conducteur (1) comportant des flancs (2) et un fond (3). Sur les flancs (2) sont rapportés des espaceurs (7) en vis à vis, ils visent à créer un canal (14) réduit entre les flancs (2). Le fond (3) et les espaceurs (7) sont tapissés d'un matériau électriquement isolant (8) délimitant une cavité vide fermée (9).

Application à la fabrication de circuits intégrés.

## Description

### DOMAINE TECHNIQUE

La présente invention est relative à la fabrication de circuits intégrés en particulier ceux utilisant un substrat en silicium. Les tranchées d'isolement creusées dans les substrats sont destinées à isoler diélectriquement et en surface les différents éléments du circuit intégré.

### ETAT DE LA TECHNIQUE ANTERIEURE

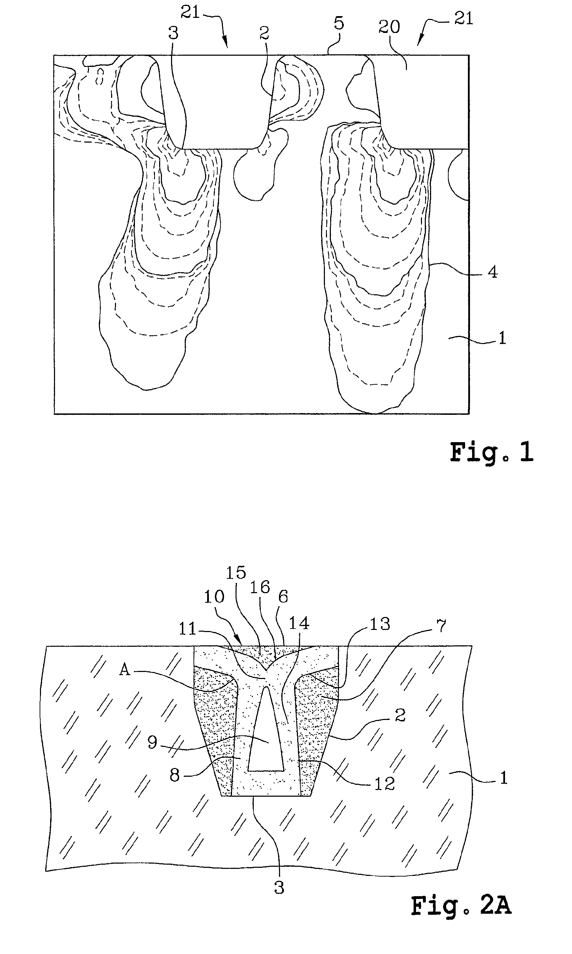

On se réfère à la figure 1 qui montre un substrat 1 en matériau semi-conducteur doté de deux tranchées d'isolement 21 voisines. Les tranchées d'isolement sont généralement creusées dans le substrat 1 en début de procédé de fabrication, elles sont séparées par des zones actives 5 qui accueillent des éléments du circuit intégré tels que par exemple transistors, diodes, résistances, condensateurs (non représentés). Elles comportent des flancs 2 et un fond 3. Elles sont pleines de matériau électriquement isolant 20. Dans les circuits en silicium qui est de loin le matériau semi-conducteur le plus utilisé dans l'industrie microélectronique, le matériau électriquement isolant est de l'oxyde de silicium.

On cherche à minimiser les dimensions surfaciques des tranchées pour diminuer la surface du circuit intégré. Il faut également que la constante diélectrique du matériau remplissant la tranchée soit la plus faible possible afin de réduire la capacité de couplage entre deux éléments du circuit intégrés situés de part et d'autre de la tranchée.

Les circuits étant de plus en plus miniaturisés, deux tranchées d'isolement 21 adjacentes sont très proches l'une de l'autre. La présence de blocs massifs 20 de matériau électriquement isolant enchâssés dans le substrat semi-conducteur 1 engendre des zones de contraintes mécaniques dans le matériau semi-conducteur. La cause en est que le matériau isolant et le matériau semi-conducteur ont des coefficients de dilatation thermiques très différents. Ces zones partent des flancs 2 et du fond 3 d'une tranchée 21 et s'étendent en profondeur et latéralement en direction de la tranchée voisine. Ces contraintes mécaniques sont accrues lorsque les tranchées n'ont pas des flancs évasés depuis le fond. Sur la figure 1, des isocontraintes 4 sont représentées dans le substrat 1 autour des tranchées 21. Les zones où elles sont fortement rapprochées sont celles soumises aux plus fortes contraintes. Si l'intensité des contraintes est trop forte, la limite d'élasticité du matériau semi-conducteur est dépassée, cela provoque des dislocations dans le matériau du substrat semi-conducteur. Le circuit est alors inutilisable.

### EXPOSÉ DE L'INVENTION

La présente invention vise à proposer une structure de tranchée d'isolement qui tout en présentant une capacité de couplage réduite n'induit pas ces fortes contraintes mécaniques dans le substrat dans lequel elle est creusée, même si elle est très proche de tranchées voisines de même type.

Pour y parvenir la tranchée d'isolement objet de l'invention comporte, dans un substrat semi-conducteur, un fond et des flancs et des espaceurs en vis à vis qui sont rapportés sur les flancs, ces espaceurs visant à créer un canal réduit entre les flancs dans le substrat semi-conducteur. Le fond et les espaceurs sont tapissés d'un même matériau électriquement isolant délimitant une cavité vide fermée.

Les espaceurs sont réalisés dans un matériau électriquement isolant.

La fermeture se fait par un bouchon réalisé par le matériau électriquement isolant qui tapisse les espaceurs et le fond. La fermeture se fait en profondeur.

En introduisant cette cavité vide, on limite la quantité de matériau électriquement isolant mise en jeu par rapport celle utilisée dans les tranchées d'isolement pleines entièrement de matériau isolant.

La cavité vide est vide de matériau solide mais est emplie d'air et/ou de gaz résiduels. Cela permet de réduire la capacité d'isolement de la tranchée car la permittivité relative de l'air ou des gaz est de l'ordre de 1 alors que celles du matériau électriquement isolant tapissant et du matériau électriquement isolant des espaceurs sont supérieures, il s'agit généralement d'oxyde de silicium de permittivité relative supérieure à 4.

Les flancs peuvent être sensiblement parallèles sur toute la profondeur de la tranchée.

Mais de préférence, les flancs sont évasés depuis le fond. Cette forme empêche de manière plus efficace l'apparition des dislocations dans le substrat. Au voisinage de l'ouverture située à l'opposé du fond, ils peuvent devenir sensiblement parallèles.

Quant au fond, il est généralement sensiblement plat.

Le canal réduit possède un facteur de forme supérieur à un, c'est un paramètre qui entre en jeu pour la formation de la cavité vide et sa fermeture.

Les espaceurs sont, de préférence, depuis le fond, sensiblement parallèles voire rentrant, puis s'évasent voire deviennent sensiblement parallèles à la surface du substrat.

Les espaceurs peuvent être en retrait par rapport à la surface du substrat, cela permet de contrôler la position en profondeur du bouchon de fermeture.

L'invention concerne également un circuit intégré doté d'au moins une tranchée d'isolement ainsi définie.

Le circuit intégré peut comporter de plus au moins une seconde tranchée d'isolement plus large que la première comportant un fond et des flancs, lesdits flancs étant dotés d'espaceurs en vis à vis, visant à créer un canal réduit entre les flancs, ce canal étant plein de matériau électriquement isolant, la tranchée d'isolement plus large étant réalisée en même temps que la première tranchée d'isolement avec la cavité vide.

La présente invention concerne aussi un procédé de réalisation d'une tranchée d'isolement dans un substrat semi-conducteur, la tranchée comportant des flancs et un fond. Il comporte les étapes suivantes :
gravure dans le substrat des flancs et du fond de la tranchée d'isolement ;
dépôt d'un matériau électriquement isolant sur le substrat visant à réaliser des espaceurs en vis à vis sur les flancs ;
gravure des espaceurs, ces derniers délimitant un canal réduit entre les flancs dans le substrat semi-conducteur ;
dépôt d'un matériau électriquement isolant qui tapisse à la fois les espaceurs et le fond et qui délimite une cavité vide fermée.

Le procédé peut comporter une étape de recuit thermique avant l'étape de dépôt du matériau électriquement isolant visant à réaliser les espaceurs de manière à restaurer l'état de surface des flancs et du fond.

Le matériau électriquement isolant qui tapisse les espaceurs et le fond forme un bouchon dont la position est ajustable.

Le matériau électriquement isolant qui tapisse les espaceurs et le fond peut être dopé et soumis à une étape de recuit thermique après son dépôt de manière à provoquer son fluage.

Lorsque la cavité vide est fermée par un bouchon de fermeture qui présente un creux en surface, le procédé peut comporter une nouvelle étape de dépôt d'un matériau électriquement isolant pour le combler.

Une étape de polissage peut intervenir pour éliminer un surplus de matériau électriquement isolant à la surface du substrat semi-conducteur.

Le dépôt du matériau électriquement isolant tapissant les espaceurs et le fond tapisse également des espaceurs et un fond d'une tranchée d'isolement plus large, sans délimiter de cavité vide fermée.

Le procédé peut comporter une étape supplémentaire de dépôt d'un matériau électriquement isolant visant à terminer le remplisssage de la tranchée d'isolement plus large.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 (déjà décrite) illustre les contraintes prenant naissance dans le matériau d'un substrat semi-conducteur dans lequel sont creusées deux tranchées d'isolement classiques ;
- les figures 2A et 2B sont des coupes de tranchées d'isolement conformes à l'invention ;
- les figures 3A à 3G illustrent différentes étapes de réalisation d'une tranchée d'isolement conforme à l'invention réalisée en même temps qu'une autre tranchée d'isolement mais plus large et pleine ;

Comme cela est habituel, dans la représentation des circuits-intégrés, les diverses figures ne sont pas tracées à l'échelle.

### EXPOSE DÉTAILLÉ DE MODES DE RÉALISATION PARTICULIERS

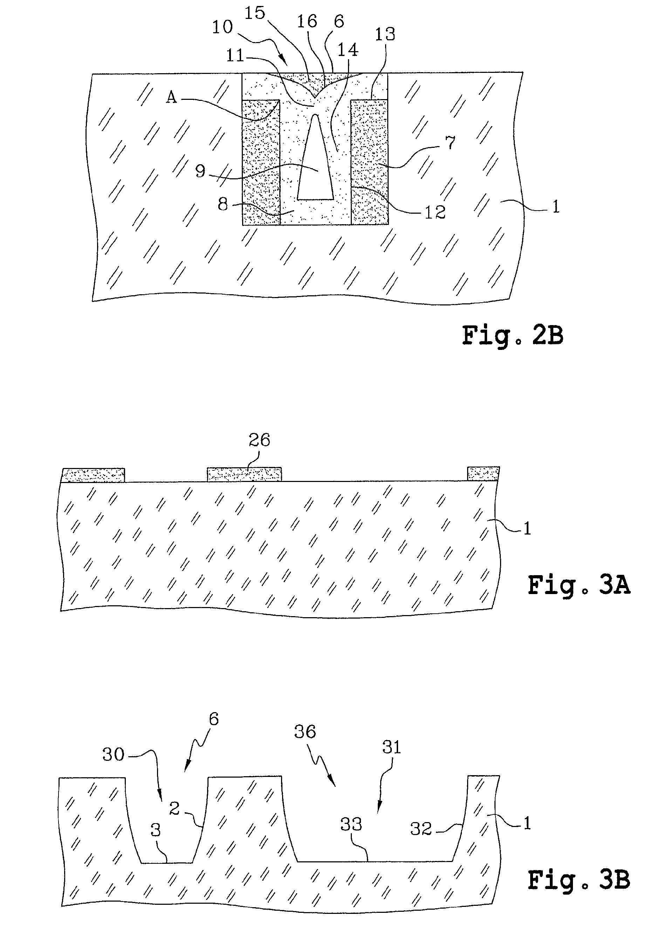

Les figures 2A et 2B montrent en coupe transversale deux exemples de tranchée d'isolement 10 conforme à l'invention. La tranchée d'isolement 10 est creusée dans un substrat semi-conducteur 1 d'un circuit intégré. Le circuit intégré est représenté schématiquement par le substrat semi-conducteur 1. Ses autres éléments ne sont pas représentés dans un souci de clarté. La tranchée d'isolement 10 comporte un fond 3, deux flancs 2 en vis à vis et une ouverture 6 à l'opposé du fond 3. Le fond 3 est sensiblement plat. Sur la figure 2A, les flancs 2 comportent une portion évasée depuis le fond 3. Cette configuration donne les meilleurs résultats au point diminution des contraintes dans le substrat 1. Les flancs peuvent ensuite en s'éloignant du fond être sensiblement parallèles. Sur la figure 2B ils sont sensiblement parallèles sur toute la profondeur de la tranchée.

Sur les flancs 2 sont rapportés des espaceurs 7, ils visent à créer un canal réduit 14 entre les flancs 2. Ces espaceurs 7 comme les flancs 2 sont en vis à vis. Ils sont réalisés dans un matériau électriquement isolant. Si les flancs 2 comportent un changement de pente, cette dernière conditionne la forme des espaceurs 7.

Les espaceurs 7 et le fond 3 sont tapissés d'un matériau électriquement isolant 8 qui délimite dans le canal 14 une cavité vide 9 fermée. La fermeture se fait par un bouchon 11 réalisé par le matériau électriquement isolant 8 qui tapisse le fond et les espaceurs. Le bouchon 11 ferme la cavité en profondeur, elle ne risquera pas de s'ouvrir lors d'éventuelles étapes de rabotage.

De préférence, les espaceurs 7 sont en retrait par rapport à la surface du substrat 1, ce qui permet d'ajuster la position en profondeur du bouchon 11.

Par cavité vide 9, on entend une cavité qui est vide de matériau solide. Dans la partie vide se trouve de l'air ou des gaz résiduels qui se forment lors du remplissage de la tranchée avec le matériau isolant 8 ou lors de traitements thermiques ultérieurs subits par le substrat 1.

Les espaceurs 7 délimitant le canal restreint ont un profil différent de celui des flancs 2. Ce profil confère au canal 14 un facteur de forme supérieur à un, ce qui signifie que sa profondeur est supérieure à sa largeur moyenne.

Plus précisément les espaceurs 7 sont sensiblement parallèles voire rentrant à partir du fond 3. En s'éloignant encore plus du fond 3, ils peuvent être évasés ou devenir sensiblement parallèles à la surface du substrat 1.

Dans l'exemple de la figure 2A, les espaceurs 7 possèdent deux portions successives 12, 13 d'inclinaisons différentes. Les premières portions 12 des espaceurs 7, les plus proches du fond 3, se rapprochent légèrement l'une de l'autre en s'éloignant du fond 3 et en allant vers l'ouverture 6. Les secondes portions 13 des espaceurs 7, les plus proches de l'ouverture 6, sont évasées en allant vers l'ouverture 6. La jonction entre les deux portions 12, 13 est référencée A. Sa position conditionne la position du bouchon de fermeture 11. Cette jonction A se trouve en profondeur dans le substrat 1.

Sur la figure 2B, les premières portions 12 des espaceurs 7, les plus proches du fond 3, sont sensiblement parallèles. Les secondes portions 13 des espaceurs 7 sont sensiblement parallèles à la surface du substrat semi-conducteur 1.

On s'intéresse maintenant aux figures 3A à 3G qui montrent différentes étapes de réalisation d'une tranchée d'isolement 30 conforme à l'invention. La tranchée 30 objet de l'invention est illustrée sur la partie gauche des figures. Sur la partie droite se trouve une tranchée d'isolement 31 plus large que la première. Les deux tranchées 30, 31 sont réalisées en même temps.

La tranchée 31 la plus large comporte des flancs 32, un fond 33, une ouverture 36 à l'opposé du fond 33. Les flancs 32 ont un profil similaire à ceux de la tranchée 30 plus étroite. Les flancs 32 sont dotés d'espaceurs 37 en vis à vis visant à créer un canal réduit 44 entre les flancs 32, ce canal étant rempli de matériau électriquement isolant. Les espaceurs 32 de la tranchée 31 large sont similaires à ceux de l'autre tranchée 30. Le matériau électriquement isolant 8 qui tapisse les espaceurs 7 et le fond 3 de la première tranchée 30 la plus étroite peut s'il est suffisamment épais remplir le canal 44 de la tranchée 31 la plus large mais il ne forme pas de cavité vide fermée.

Les tranchées larges ne présentent pas de cavité vide. Leurs réalisation est compatible avec la réalisation des tranchées étroites. Les tranchées larges génèrent, à cause de leurs dimensions importantes des capacités de couplage faibles ainsi que des contraintes réduites dans le substrat, même lorsqu'elles sont remplies, de manière homogène, d'un matériau diélectrique.

On part d'un substrat 1 de matériau semi-conducteur, base des circuits intégrés. On commence par y déposer de la résine photosensible 26. On va ensuite déterminer le motif des tranchées d'isolement 30, 31, ce motif correspond aux ouvertures 6, 36 des tranchées. On transfère ce motif sur la résine 26 et on la développe (figure 3A).

Une première étape de gravure intervient pour former les flancs 2, 32 et le fond 3, 33 des tranchées d'isolement 30, 31. La gravure peut être une gravure sèche assistée par plasma, par exemple une gravure réactive RIE. On retire ensuite la résine 26 (figure 3B).

Sur la figure 3B, les flancs 2, 32 sont rentrants en se rapprochant du fond 3, 33. Pour graver les flancs rentrant, il est possible d'utiliser un mélange d'acide bromhydrique HBr et d'oxygène O₂. Pour graver des flancs 2, 32 sensiblement parallèles, on peut utiliser un mélange gazeux de chlore Cl₂, d'oxygène O₂, d'acide bromhydrique HBr. Si les flancs 2, 32 étaient configurés comme sur la figure 2A, en étant, depuis l'ouverture sensiblement parallèles puis rentrant, la gravure se ferait en deux temps. On graverait d'abord les flancs sensiblement parallèles puis les flancs rentrant. On peut utiliser un même mélange gazeux pour graver les deux parties, par exemple un mélange d'acide bromhydrique HBr et d'oxygène O₂, en modifiant de manière appropriée les paramètres physiques de gravure, c'est à dire la puissance RF utilisée pour créer le plasma, la pression, les proportions des gaz.

La largeur de la tranchée 30 dotée de la cavité vide est du même ordre de grandeur que sa profondeur, par exemple la largeur est comprise entre 0,2 et 0,4 micromètre. Elle est choisie en fonction des éléments qu'elle doit isoler.

On peut ensuite soumettre les tranchées 30, 31 à un recuit de type RTO (Rapid Thermal Oxidation pour oxydation thermique rapide) de manière à restaurer l'état de surface de leurs flancs 2, 32 et de leur fond 3, 33 endommagés par la gravure et donc à limiter la circulation de courants de fuite qui pourraient prendre naissance au niveau de ces surfaces endommagées.

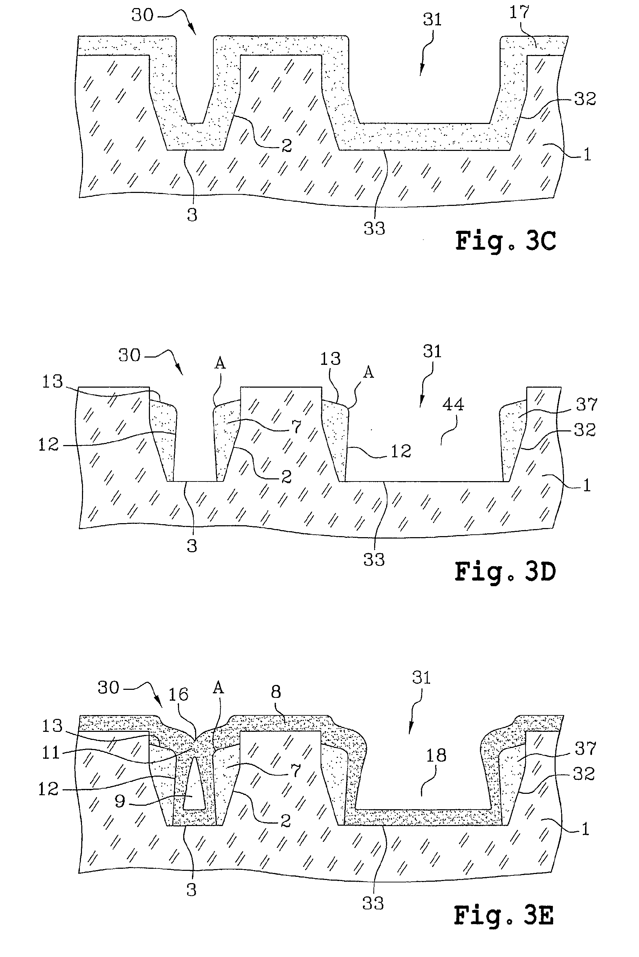

On va pouvoir réaliser les espaceurs 7, 37. On commence par réaliser un dépôt d'un matériau électriquement isolant 17 sur le substrat 1, le long des flancs 2, 32 et sur le fond 3, 33 des tranchées 30, 31. Dans l'exemple, il s'agit de l'oxyde de silicium si le substrat 1 est en silicium mais d'autres matériaux diélectriques tels que le nitrure de silicium pourraient être employés, ils conduisent à des résultats de topographies équivalentes. Dans cet exemple particulier le dépôt est conforme et l'épaisseur déposée le long des flancs 2, 32 est sensiblement la même qu'au fond 3, 33 et à la surface du substrat 1 (figure 3C). La conformité du dépôt n'est pas une nécessité. L'épaisseur de matériau isolant 17 peut être comprise entre 50 et 150 nanomètres par exemple.

Un tel dépôt peut se faire par exemple par réactions chimiques en phase vapeur par décomposition de tétraéthylorthosilicate connu sous l'abréviation de TEOS. Ensuite, on grave par exemple par plasma, sans masque, de manière directionnelle la couche d'isolant déposée 17 de manière à l'éliminer au fond 3, 33 des tranchées 30, 31 à la surface du substrat 1 et à configurer les espaceurs 7, 37 avec le profil voulu. Dans l'exemple on réalise pour chacun des espaceurs des portions 12, 13 successives d'inclinaisons différentes comme décrit précédemment (figure 3D).

Si la première portion 12 des espaceurs 7, 37 est légèrement évasée en se rapprochant du fond 3, 33 il faut prévoir une opération de surgravure latérale pour obtenir le profil souhaité. Cette gravure latérale est obtenue par les espèces chimiques très réactives qui se forment dans le plasma. Un mélange gazeux de fluorure de carbone par exemple C₄F₈, d'argon et d'oxygène par exemple peut être employé.

L'étape suivante est une étape de remplissage des tranchées d'isolement 30, 31 avec le matériau électriquement isolant 8 qui tapisse les espaceurs 7, 37 et le fond 3, 33. Dans la tranchée d'isolement 30 la plus étroite, le matériau électriquement isolant 8 délimite la cavité vide 9 fermée.

Le matériau électriquement isolant 8 contribue à remplir le canal réduit 44 de la tranchée d'isolement 31. Un creux 18 subsiste dans la tranchée la plus large 31. Une épaisseur importante de matériau électriquement isolant 8 pourrait éventuellement remplir totalement la tranchée d'isolement 31 la plus large. Les espaceurs 37 sont trop espacés pour qu'une cavité vide fermée puisse se créer.

Cette étape peut être un dépôt non conforme d'oxyde par exemple. Il est connu de l'homme du métier que de nombreuses méthodes de dépôt de matériau électriquement isolant conduisent à un dépôt non conforme. Par exemple ce dépôt peut se faire par réactions chimiques en phase vapeur CVD, réactions chimiques en phase vapeur assistées par plasma PECVD avec au moins un précurseur rendant le dépôt non conforme. Comme précurseur on peut utiliser du TEOS ou du silane SiH₄ avec de l'oxygène par exemple. Et ce dépôt conduit à la formation prématurée du bouchon.

Un dépôt non conforme se fait plus rapidement sur les surfaces horizontales que sur les surfaces verticales. Ce dépôt se fait donc plus rapidement sur la seconde portion 13 des espaceurs 7, 37 que sur la première partie 12. Au niveau de la tranchée 30 la plus étroite, la cavité vide 9 se forme ainsi que le bouchon 11 qui la ferme en profondeur. Le bouchon 11 se situe au voisinage de la jonction A (figure 3E).

Si les espaceurs ont un profil rentrant approprié un dépôt conforme de matériau électriquement isolant 8 conviendrait.

Le matériau électriquement isolant 8 peut être dopé, par exemple l'oxyde de silicium peut être dopé au bore ou au phosphore. Une étape de recuit thermique intervient ensuite pour faire diffuser les atomes de dopant et ce recuit thermique provoque un fluage du matériau électriquement isolant 8 le long des espaceurs 7, 37 ce qui permet d'ajuster, dans la tranchée 30 étroite la position du bouchon de fermeture 11.

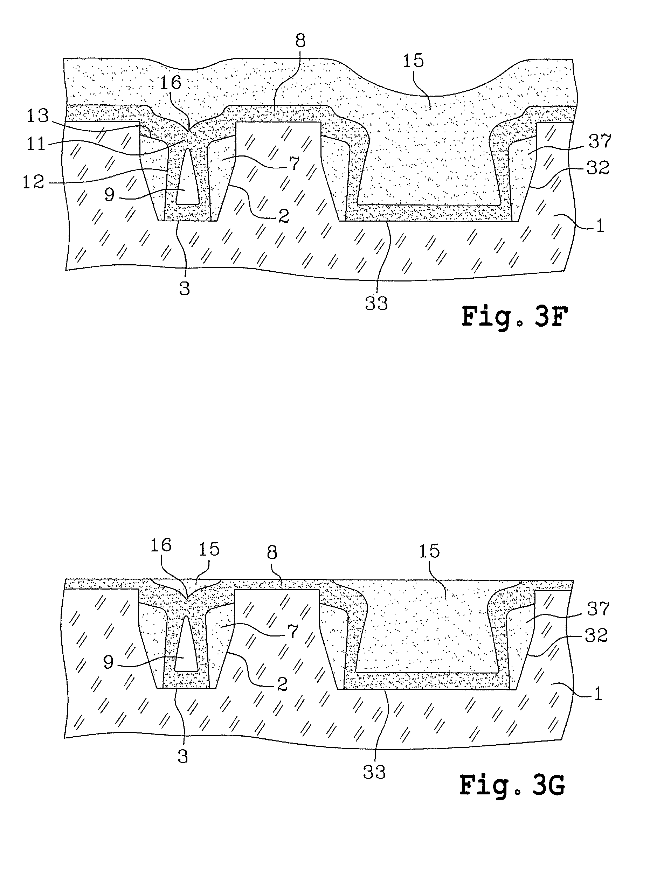

Lorsque la tranchée 31 la plus large est pleine, on peut réaliser par une étape de polissage mécano-chimique CMP pour éliminer le surplus d'oxyde à la surface du substrat 1, cette étape se fait sans risque d'ouvrir la cavité vide 9 puisque son bouchon 11 la ferme en profondeur. Dans l'exemple décrit, on suppose que le dépôt non conforme de matériau électriquement isolant 8 n'a pas rempli la tranchée 31 et que l'étape de polissage se fait ultérieurement (figure 3G).

Lorsque la tranchée d'isolement 30 dotée de la cavité vide est relativement large par rapport à sa profondeur et que le matériau électriquement isolant 8 qui forme la cavité vide 9 n'a pas une épaisseur suffisante, le bouchon 11 peut présenter un creux 16 en surface comme sur la figure 2A. Un nouveau dépôt de matériau électriquement isolant 15 peut être réalisé pour le combler (figure 3F). Cette étape intervient de préférence avant le polissage. Le matériau électriquement isolant 15 déposé peut être de l'oxyde de silicium ou du nitrure de silicium par exemple. Ce nouveau dépôt de matériau électriquement peut être par exemple un dépôt conforme.

Si la tranchée d'isolement 31 la plus large n'a pu être remplie par le matériau électriquement isolant 8, il est alors possible d'effectuer, avant l'étape de polissage, un dépôt supplémentaire de matériau électriquement isolant 15, nitrure ou oxyde par exemple, pour terminer de la remplir (figure 3F). On réalise ensuite l'étape de polissage (figure 3G). Ce dépôt de matériau électriquement isolant peut être celui qui comble le creux 16 du bouchon 11. Ce dépôt supplémentaire de matériau isolant 15 peut être un dépôt conforme par exemple.

## Revendications

1. Tranchée d'isolement creusée dans un substrat semi-conducteur (1) comportant des flancs (2) et un fond (3), **caractérisée en ce qu'**elle comporte des espaceurs (7) en vis à vis rapportés sur les flancs (2), ces espaceurs (7) visant à créer un canal (14) réduit entre les flancs (2) dans le substrat semi-conducteur, les espaceurs (7) et le fond (3) étant tapissés d'un même matériau électriquement isolant (8) délimitant une cavité vide (9) fermée.

2. Tranchée d'isolement selon la revendication 1, **caractérisée en ce que** les espaceurs (7) sont en matériau électriquement isolant.

3. Tranchée d'isolement selon l'une des revendications 1 ou 2, **caractérisée en ce que** la fermeture de la cavité se fait en profondeur par un bouchon (11) réalisé par le matériau électriquement isolant (8) tapissant les espaceurs (7) et le fond (3).

4. Tranchée d'isolement selon la revendication 3, **caractérisée en ce que** lorsque le bouchon (11) présente un creux (16) en surface, le creux est rempli de matériau électriquement isolant (15).

5. Tranchée d'isolement selon l'une des revendications 1 à 4, **caractérisée en ce que** les flancs (2) sont évasés depuis le fond (3).

6. Tranchée d'isolement selon la revendication 5, **caractérisée en ce que** les flancs (2) sont sensiblement parallèles à l'opposé du fond (3).

7. Tranchée d'isolement selon l'une des revendications 1 à 4, **caractérisée en ce que** les flancs (2) sont sensiblement parallèles sur toute la profondeur de la tranchée.

8. Tranchée d'isolement selon l'une des revendications 1 à 7, **caractérisée en ce que** le fond (3) est sensiblement plat.

9. Tranchée d'isolement selon l'une des revendications 1 à 8, **caractérisée en ce que** le canal (14) a un facteur de forme supérieur à un.

10. Tranchée d'isolement selon l'une des revendications 1 à 9, **caractérisée en ce que** les espaceurs (7) sont, depuis le fond (3), d'abord sensiblement parallèles voire rentrant, puis s'évasent voire deviennent sensiblement parallèles à la surface du substrat (1).

11. Tranchée d'isolement selon l'une des revendications 1 à 10, **caractérisée en ce que** les espaceurs (7) sont en retrait par rapport à la surface du substrat (1).

12. Circuit intégré, **caractérisé en ce qu'**il comporte au moins une tranchée d'isolement (30) selon l'une des revendications 1 à 11.

13. Circuit intégré selon la revendication 12, **caractérisé en ce qu'**il comporte de plus au moins une autre tranchée d'isolement (31), plus large que la première, comportant un fond (33) et des flancs (32) dotés d'espaceurs (37) en vis à vis, visant à créer un canal réduit (44) entre les flancs (32), ce canal (44) étant plein de matériau électriquement isolant (8, 15), la tranchée d'isolement (31) plus large étant réalisée en même temps que la tranchée d'isolement (30) avec la cavité vide (9).

14. Procédé de réalisation d'une tranchée d'isolement (10) dans un substrat semi-conducteur (1), la tranchée comportant des flancs (2) et un fond (3), **caractérisé en ce qu'**il comporte les étapes suivantes :
gravure dans le substrat (1) des flancs (2) et du fond (3) de la tranchée d'isolement ;
dépôt d'un matériau électriquement isolant (17) sur le substrat (1) visant à réaliser des espaceurs (7) en vis à vis sur les flancs (2) ;
gravure des espaceurs (7), ces derniers délimitant un canal (14) réduit entre les flancs (2) dans le substrat semi-conducteur ;
dépôt d'un matériau électriquement isolant (8) qui tapisse à la fois les espaceurs (7) et le fond (3) et qui délimite une cavité vide (9) fermée.

15. Procédé de réalisation d'une tranchée d'isolement (10) selon la revendication 14, **caractérisé en ce que** le matériau électriquement isolant (8) qui tapisse les espaceurs (7) et le fond (3) forme un bouchon (11) dont la position est ajustable.

16. Procédé de réalisation d'une tranchée d'isolement (10) selon l'une des revendications 14 à 15, **caractérisé en ce qu'**il comporte une étape de recuit thermique avant l'étape de dépôt du matériau électriquement isolant (17) visant à réaliser les espaceurs de manière à restaurer l'état de surface des flancs (2) et du fond (3).

17. Procédé de réalisation d'une tranchée d'isolement (10) selon l'une des revendications 14 à 16, **caractérisé en ce qu'**il comporte une étape de recuit thermique après l'étape de dépôt du matériau électriquement isolant (8) tapissant le fond (3) et les espaceurs (7) de manière à faire fluer ledit matériau lorsqu'il est dopé.

18. Procédé de réalisation d'une tranchée d'isolement selon l'une des revendications 14 à 17, **caractérisé en ce que**, lorsque la cavité vide (9) est fermée par un bouchon de fermeture (11) qui présente un creux (16) en surface, il comporte une nouvelle étape de dépôt d'un matériau électriquement isolant (15) pour le combler.

19. Procédé de réalisation d'une tranchée d'isolement selon l'une des revendications 14 à 18, **caractérisé en ce qu'**il comporte une étape de polissage pour éliminer un surplus de matériau électriquement isolant (8, 15) à la surface du substrat semi-conducteur (1).

20. Procédé de réalisation d'une tranchée d'isolement selon l'une des revendications 14 à 19, **caractérisé en ce que** le dépôt du matériau électriquement isolant (8) tapissant les espaceurs (7) et le fond (3), tapisse également des espaceurs (37) et un fond (33) d'une tranchée d'isolement (31) plus large, sans délimiter de cavité vide fermée.

21. Procédé de réalisation d'une tranchée d'isolement selon la revendication 20, **caractérisé en ce qu'**il comporte une étape supplémentaire de dépôt d'un matériau électriquement isolant (15) visant à terminer le remplissage de la tranchée d'isolement plus large (31).
